**Europäisches Patentamt**

**European Patent Office**

**Office européen des brevets**

(19)

(11) Numéro de publication : **0 197 078 B1**

# (12) FASCICULE DE BREVET EUROPÉEN

(45) Date de publication du fascicule du brevet :
07.03.90

(21) Numéro de dépôt : 85904827.4

(22) Date de dépôt : 01.10.85

(86) Numéro de dépôt international :
PCT/FR 85/00270

(87) Numéro de publication internationale :
WO/8602198 (10.04.86 Gazette 86/08)

(51) Int. Cl.$^5$ : **H 01 L 21/20**, H 01 L 21/76,
H 01 L 21/324

(54) PROCEDE DE FABRICATION D'ILOTS DE SILICIUM MONOCRISTALLIN ISOLES ELECTRIQUEMENT LES UNS DES AUTRES.

(30) Priorité : 05.10.84 FR 8415302

(43) Date de publication de la demande :
15.10.86 Bulletin 86/42

(45) Mention de la délivrance du brevet :
07.03.90 Bulletin 90/10

(84) Etats contractants désignés :
DE FR GB

(56) Documents cités :
EP–A– 0 141 506
DE–A– 3 221 304
US–A– 4 507 158
International Electron Devices Meeting Washington D.C., 8-9-10 December 1980, IEDM Technical Digest, New York, (US) H.W. Lam et al.: "MOSFETs fabricated in (100) single crystal silicon-on-oxide obtained by a laser-induced lateral seeding technique", pages 559-561
International Electron Devices Meeting San Francisco C.A., 13-14-15 December 1982, IEDM Technical Digest, IEEE, New York, (US) S.D.S. Malhi et al.:SOI CMOS circuit performance on graphite strip heater recrystallized material", pages 441-443

(73) Titulaire : **Haond, Michel**
**9, rue des Lilas**
**F-38240 Meylan (FR)**

**Colinge, Jean-Pierre**
**5 av. du Vercors**
**F-38240 Meylan (FR)**

**Bensahel, Daniel**
**32 rue Lachman**
**F-38000 Grenoble (FR)**

**DUTARTRE, Didier**
**4, allée du Bret**
**F-38240 Meylan (FR)**

(72) Inventeur : **Haond, Michel**
**9, rue des Lilas**
**F-38240 Meylan (FR)**
Inventeur : **Colinge, Jean-Pierre**
**5 av. du Vercors**
**F-38240 Meylan (FR)**
Inventeur : **Bensahel, Daniel**
**32 rue Lachman**
**F-38000 Grenoble (FR)**
Inventeur : **DUTARTRE, Didier**
**4, allée du Bret**
**F-38240 Meylan (FR)**

Japanese Journal of Applied Physics, Supplements 1983, Supplement 15th Conference Tokyo, (JP) H. Yamamoto et al.: "Growth conditions of evaporated amorphous Si films into SIO2 patterns by lateral solid phase epitaxy", pages 89-92

IBM Technical Disclosure Bulletin, volume 24, No. 78, December 1981, New York, (US) V.J. Silvestri: "Silicon-Silicon Dioxide-Silicon structures", pages 3689-3690

Journal of the Electrochemical Society, volume 131, No. 8, August 1984, Manchester, New Hampshire (US) D.R. Bradbury et al.: "Device Isolation in lateral CVD epitaxial silicon-on-Insulator", page 320C

(74) Mandataire : **Mongrédien, André et al** **c/o BREVATOME 25, rue de Ponthieu** **F-75008 Paris (FR)**

## Description

La présente invention a pour objet un procédé de fabrication d'îlots de silicium monocristallin isolés électriquement les uns des autres. Elle s'applique en particulier dans le domaine de la fabrication des circuits intégrés MOS ou bipolaires, du type silicium sur isolant, dans lesquels des composants fonctionnant sous « haute tension » doivent être électriquement isolés de composants fonctionnant en « basse tension ».

La technologie silicium sur isolant ou technologie SSI, utilisée pour la fabrication d'îlots de silicium monocristallin isolés les uns des autres, constitue une amélioration sensible par rapport aux techniques standard dans lesquelles les composants actifs des circuits intégrés sont réalisés directement sur un substrat monocristallin en silicium massif. En effet, l'emploi d'un corps isolant conduit à une forte diminution des capacités parasites entre la source et le substrat d'une part, et le drain et le substrat d'autre part, des composants actifs des circuits intégrés et donc à un accroissement de la vitesse de fonctionnement de ce circuit ; il conduit aussi à une simplification notable des procédés de fabrication, une augmentation de la densité d'intégration, et à une meilleure tenue des circuits aux hautes tensions.

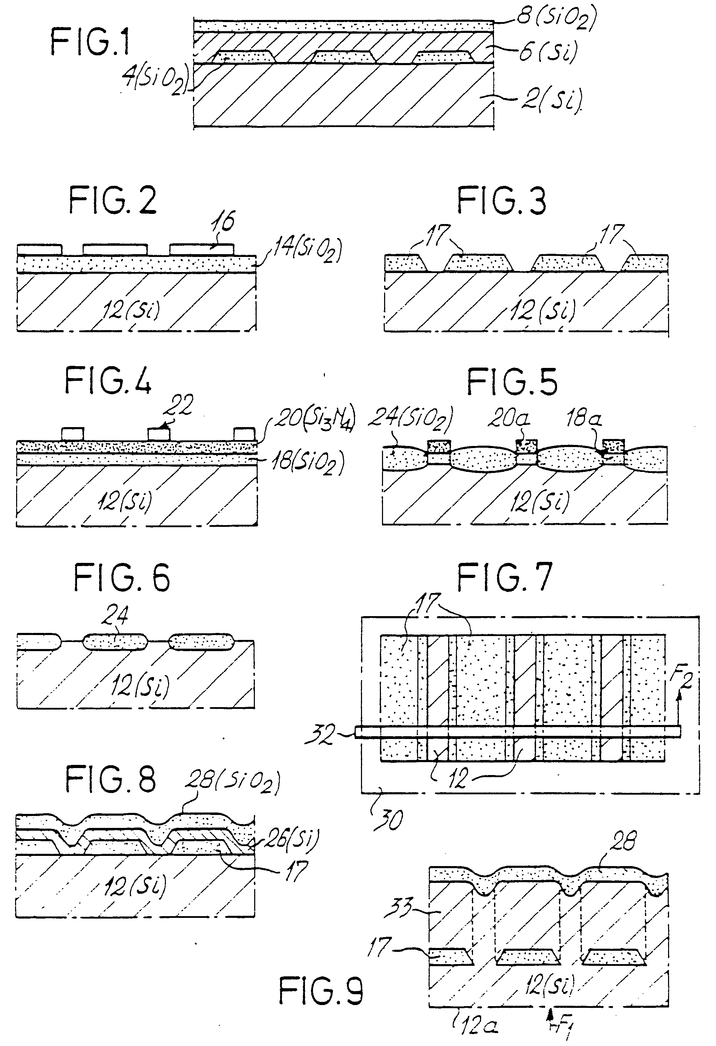

L'une des techniques actuellement connues pour réaliser une couche de silicium monocristallin sur un support isolant est représentée schématiquement, en coupe longitudinale, sur la figure 1 annexée. Cette technologie consiste à former sur un substrat 2 en silicium monocristallin de type n ou p des motifs 4 d'oxyde de silicium, puis à former, par dépôt en phase gazeuse, une couche épaisse de silicium polycristallin 6 surmontant lesdits motifs d'oxyde. On réalise ensuite sur l'ensemble de la couche en silicium polycristallin 6 le dépôt d'une couche isolante d'oxyde de silicium 8 notamment par un procédé de dépôt chimique en phase gazeuse (LPCVD).

L'étape suivante consiste à recristalliser la couche de silicium polycristallin 6 sous forme monocristalline. Cette recristallisation consiste à faire fondre le silicium de la couche 6 en le chauffant, à travers la couche d'oxyde 8, au moyen d'une source de chauffage en forme de sole chauffante ; la couche de silicium 6 en se refroidissant, se recristallise sous forme monocristalline, à partir du substrat 2 qui sert alors de germe à la croissance.

Dans cette couche de silicium monocristalline peuvent ensuite être réalisés des îlots de silicium monocristallin isolés les uns des autres.

Ce procédé d'obtention d'une couche de silicium monocristallin sur une couche d'oxyde a notamment été décrit dans un article de Materials Research Society Symposia Proceedings, vol. 13, 1983 intitulé « Lateral epitaxial growth of thick polysilicon films on oxydized 3-inch wafers » de G.K. CELLER et al, pages 575 à 580.

Ce procédé présente un certain nombre d'inconvénients. En particulier, la surface de la couche 6 en silicium recristallisée présente une rugosité souvent élevée et la surface des zones recristallisées se trouvant sur les motifs d'oxyde 4 n'est nullement plane ; ces états de surface imposent une étape supplémentaire de polissage de la surface de la couche 6 recristallisée. Par ailleurs, ce procédé présente un rendement faible ; en effet, le rapport des zones recristallisées sur isolant/zones non utilisées, par plaquettes de silicium, est de l'ordre de 50 %. De plus, ce procédé utilise un dépôt par épitaxie de la couche de silicium à recristalliser, dépôt généralement long et difficile à réaliser. Enfin, l'alignement des masques de résine futurs pour réaliser les composants au-dessus des motifs isolants 4 est difficile à obtenir par photolithographie car le silicium recristallisé de la couche 6 n'est plus transparent dans le domaine d'irradiation généralement utilisé pour l'alignement des masques.

Par ailleurs, on connaît par le document EP-A-0 141 506 une modification du procédé précédent d'obtention d'une couche de silicium monocristallin, consistant en un balayage du film de silicium selon une direction [110], améliorant l'état cristallin de la couche de silicium. Ce document concerne l'art antérieur selon l'article 54(3) de la convention sur le brevet européen.

La présente invention a pour objet un procédé de fabrication d'îlots de silicium monocristallin isolés électriquement les uns des autres permettant, entre autre, de remédier aux différents inconvénients donnés ci-dessus.

Selon l'invention, le procédé de fabrication comprend les étapes successives suivantes :

a) réalisation de bandes parallèles continues en un premier matériau isolant sur un substrat en silicium monocristallin,

b) dépôt sur l'ensemble de la structure d'un film de silicium non-monocristallin,

c) recouvrement du film de silicium d'une couche continue d'un matériau encapsulant,

d) réalisation d'un traitement thermique de la structure obtenue servant à enfoncer verticalement dans le substrat les bandes de premier matériau isolant et à former au-dessus de ces bandes enfoncées une couche de silicium monocristallin, ce traitement thermique, consistant à chauffer d'une part la face du substrat en silicium opposée au film de silicium, de façon uniforme, à une température inférieure à la température de fusion du silicium et, d'autre part, le film de silicium, en effectuant un balayage relatif entre une source de chauffage et le film, suivant une direction parallèle auxdites bandes, ces chauffages simultanés du film et de ladite face du substrat induisant une zone fondue de silicium se déplaçant sur toute la surface du film et du substrat selon ladite direction,

e) éliminer la couche de matériau encapsulant, et

f) graver la couche de silicium monocristallin obtenue de façon à former lesdits îlots.

Le film de silicium peut être un film de silicium polycristallin ou un film de silicium amorphe.

Le procédé de l'invention permet notamment d'obtenir des îlots en silicium monocristallin isolés les uns des autres exempts de tous défauts cristallins. Par ailleurs, la surface de la couche de silicium monocristallin obtenue est lisse et plane et notamment au-dessus des bandes isolantes, ce qui permet d'éviter, par rapport à l'art antérieur, une étape supplémentaire de polissage de la surface de ladite couche monocristalline. Cet avantage est accru dans la variante de l'invention dans laquelle le film mince de silicium déposé est un film mince de silicium amorphe, car un tel film présente un excellent état de surface (surface lisse).

En outre, le rendement par plaquettes de ce procédé est plus élevé que dans l'état de la technique ; en effet, le rapport des zones recristallisées sur isolant/zones non utilisées est voisin de 80 %.

De préférence, les bandes parallèles continues sont régulièrement espacées les unes des autres.

De façon avantageuse, le film de silicium est chauffé au moyen d'une source de chauffage de forme allongée.

Le balayage relatif selon l'invention entre la source et le film de silicium, suivant une direction parallèle auxdites bandes permet d'éviter tous légers déplacements latéraux des bandes de premier matériau isolant, lorsque ceux-ci s'enfoncent dans le substrat monocristallin.

Selon un mode préféré de mise en œuvre du procédé de l'invention, on effectue l'étape f) de la façon suivante :

réalisation d'un masque sur la couche de silicium obtenue représentant l'image des bandes en premier matériau isolant,

élimination des régions de la couche de silicium non masquées jusqu'au niveau des bandes de premier matériau isolant enfoncées dans le substrat, et

élimination du masque.

Selon un autre procédé de mise en œuvre du procédé de l'invention, on effectue, après l'étape f), le recouvrement des flancs des îlots et des régions du substrat mises à nu entre lesdits îlots d'une couche d'un deuxième matériau isolant.

De façon avantageuse, on effectue, après l'étape f) un remplissage des espaces compris entre les îlots par un troisième matériau qui est, de préférence, une résine polyimide.

D'autres caractéristiques et avantages de l'invention ressortiront mieux de la description qui va suivre, donnée à titre illustratif et non limitatif, en référence aux figures annexées, dans lesquelles :

la figure 1, déjà décrite, illustre schématiquement, en coupe longitudinale, les différentes étapes d'un procédé de fabrication d'une couche de silicium monocristallin conformément à l'art antérieur, dans laquelle peuvent être réalisés des îlots de silicium,

les figures 2, 3, 8 à 14 illustrent schématiquement, en coupe longitudinale, les différentes étapes du procédé conformément à l'invention,

les figures 4 à 6 illustrent schématiquement une variante de ce procédé, et

la figure 7 illustre schématiquement un dispositif permettant la mise en œuvre du procédé de l'invention.

Les premières étapes du procédé consistent à réaliser des motifs en un matériau isolant (figures 3 et 6) sur un substrat en silicium monocristallin.

Pour cela on réalise tout d'abord, selon une première variante représentée sur la figure 2, le recouvrement d'un substrat 12 en silicium monocristallin de type n ou p, constitué par exemple par une plaquette de silicium coupée suivant le plan cristallographique 100, d'une couche 14 d'un premier matériau isolant réalisé de préférence en oxyde de silicium. Cette couche isolante 14 peut être obtenue par oxydation thermique du substrat 12, sous oxygène sec ou humide à une température de l'ordre de 800 à 1 100 °C, ou bien être déposée sur le substrat par un procédé de dépôt chimique en phase gazeuse (pyrolyse vers 420 °C de $SiH_4$ et $O_2$). Cette couche d'oxyde 14 présente par exemple une épaisseur de l'ordre de 1 µm.

On réalise ensuite sur la couche d'oxyde de silicium 14 un masque 16 de résine, par les procédés classiques de photolithographie pour définir les dimensions des motifs d'oxyde à réaliser dans la couche 14. On effectue ensuite, comme représenté sur la figure 3, une gravure de la couche d'oxyde 14 de façon à mettre à nu les régions du substrat non recouvertes par le masque 16. Cette gravure peut être réalisée de façon anisotrope en utilisant un procédé de gravure par plasma ou bien de façon isotrope par exemple par voie chimique en utilisant comme agent d'attaque de l'acide fluorhydrique. La structure représentée sur la figure 3 résulte d'une gravure de type chimique.

On réalise ensuite l'élimination du masque 16 notamment par voie chimique ou par attaque d'un plasma d'oxygène. Les motifs isolants ainsi obtenus sur le substrat 12 portent la référence 17.

Sur les figures 4 à 6, on a représenté une autre variante de réalisation des motifs en matériau isolant sur le substrat 12.

Comme représenté sur la figure 4, on réalise tout d'abord une oxydation thermique du substrat 12, sous oxygène à une température de l'ordre de 1 000 °C, de façon à obtenir une couche 18 en oxyde de silicium. Cette couche d'oxyde 18 présente une épaisseur de l'ordre de 60 nm.

Sur cette couche d'oxyde 18, on réalise ensuite le dépôt d'une couche isolante 20, notamment en nitrure de silicium, par un procédé de dépôt chimique en phase vapeur à basse pression (pyrolyse de $NH_3$ + $SiH_2Cl_2$ à 800 °C). Cette couche présente une épaisseur de l'ordre de 80 nm. Cette couche servira, ultérieurement de masque pour définir les dimensions des motifs de matériau isolant disposés au-dessus du substrat.

On réalise ensuite, sur la couche de nitrure 20 un masque de résine 22, complémentaire du masque 16 (figure 2) permettant de définir dans la couche de nitrure 20 des motifs complémentaires 20a (figure 5) de ceux à obtenir sur le substrat 12. Puis on effectue une élimination des régions de la couche de nitrure 20 non masquées, de façon à mettre à nu les régions de la couche d'oxyde de silicium 18 sous-jacentes. Cette élimination peut être réalisée par un procédé de gravure anisotrope ou isotrope et en particulier par attaque chimique en utilisant de l'acide orthophosphorique comme agent d'attaque ou par attaque d'un plasma fluoré.

A l'aide de la couche de nitrure 20 gravée et éventuellement du masque 22, on réalise ensuite, de la même façon, une gravure de la couche d'oxyde 18 jusqu'à mise à nu des régions du substrat non recouvertes par la couche gravée 20. Les motifs réalisés dans la couche d'oxyde 18 portent la référence 18a (figure 5). Cette gravure peut être réalisée de façon anisotrope ou isotrope par exemple par attaque chimique en utilisant comme agent d'attaque de l'acide fluorhydrique. La structure obtenue est représentée sur la figure 5. L'élimination du masque de résine 22 peut être réalisée par voie chimique avec comme agent d'attaque de l'acétone.

L'étape suivante du procédé consiste à effectuer une oxydation thermique des zones du substrat mises à nu, sous oxygène sec ou humide à une température comprise entre 800 et 1 100 °C. Cette oxydation thermique permet d'obtenir des motifs d'oxyde 24, partiellement enterrés dans le substrat 12. On réalise ensuite une élimination, par exemple par voie chimique avec de l'acide orthophosphorique, du restant 20a de la couche de nitrure, puis on élimine le restant 18a de la couche d'oxyde par exemple par voie chimique avec de l'acide fluorhydrique. La structure obtenue est représentée sur la figure 6. Cette technologie est généralement connue sous le nom de technologie LOCOS.

Il est aussi possible, selon l'invention, de réaliser des motifs isolants 24 complètement enterrés dans le substrat 12 pour cela, il suffit de réaliser, après les gravures des couches 18 et 20 respectivement d'oxyde et de nitrure de silicium (figure 5), une gravure sur une certaine hauteur (voisine de 300 nm), des régions du substrat non recouvertes par le restant 18a et 20a des couches correspondantes. Cette gravure peut être réalisée par un procédé de gravure isotrope et notamment par voie chimique en utilisant une solution de potasse.

De façon avantageuse, les motifs d'oxyde 17 ou 24, réalisés respectivement sur le substrat 12 ou bien enterrés dans celui-ci, présentent de préférence, comme représenté sur la figure 7 montrant en une vue de dessus la structure de la figure 3, la forme de bandes parallèles continues, régulièrement espacées les unes des autres et s'étendant d'un bout à l'autre du substrat 12, autrement dit de la plaquette de silicium. Ces bandes d'isolant 17 sont réparties de façon uniforme sur toute la surface du substrat 12. Par exemple pour une plaquette de silicium de 100 mm² il est possible de réaliser des bandes d'isolant 17 de 10 à 20 $\mu$m de large, espacées les unes des autres de 4 $\mu$m.

Les étapes suivantes du procédé concernent bien entendu des motifs isolants 17 ou 24, obtenus sur le substrat ou dans le substrat selon les différentes variantes décrites précédemment. Cependant, de façon à faciliter la description qui va suivre, celle-ci se fera en utilisant des motifs isolants de référence 17, obtenus dans une couche isolante par gravure de ladite couche conformément à la première variante décrite en regard des figures 2 et 3.

Comme représenté sur la figure 8, on dépose sur l'ensemble de la structure un film de silicium 26 polycristallin ou amorphe présentant par exemple une épaisseur de l'ordre de 0,5 $\mu$m. Le film de silicium polycristallin peut être obtenu par un procédé de dépôt chimique en phase vapeur à basse pression, à une température de l'ordre de 600 °C par pyrolyse de $SiH_4$. De même, le film de silicium amorphe peut être obtenu par dépôt en phase vapeur à basse température (inférieure à 550 °C) et basse pression.

On recouvre ensuite le film 26 d'une couche d'encapsulation 28, réalisée par exemple en oxyde de silicium ou en nitrure de silicium ou même sous forme multicouche, une couche d'oxyde de silicium et une couche de nitrure de silicium. Cette couche encapsulante 28, présentant par exemple une épaisseur de 1,5 à 2 $\mu$m, peut être obtenue par un procédé de dépôt chimique en phase vapeur à basse pression, à 430 °C par pyrolyse de $(SiH_4 + O_2)$ lorsque ladite couche est en oxyde de silicium.

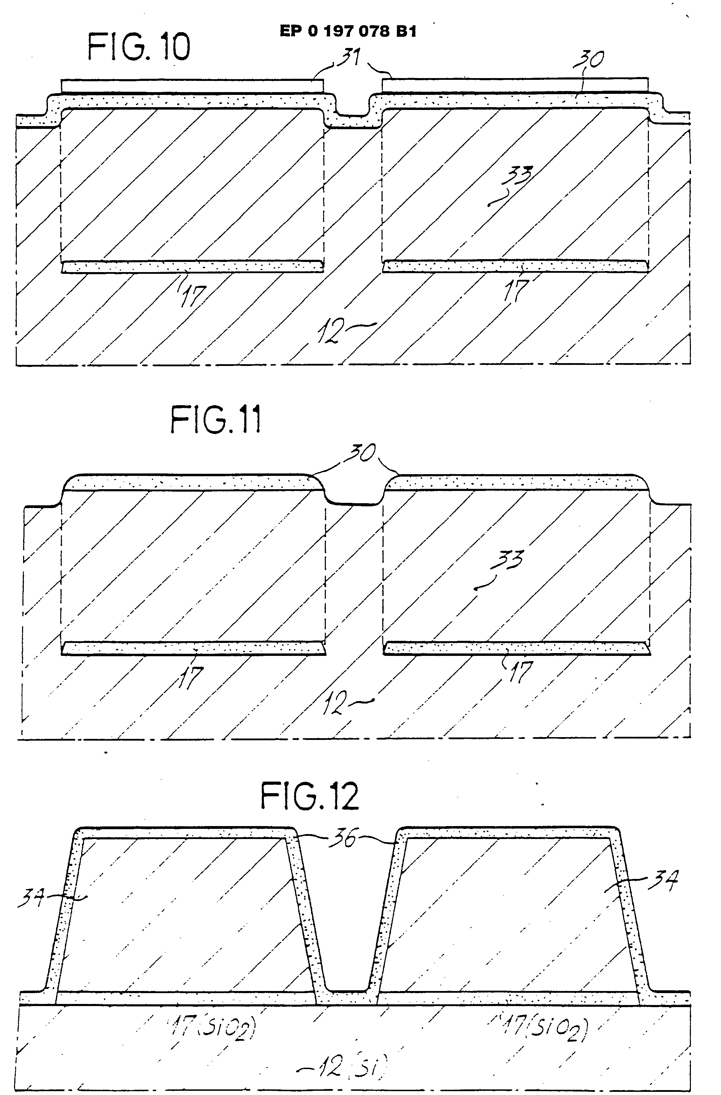

L'étape suivante du procédé consiste à soumettre la structure obtenue à un traitement thermique. Ce traitement thermique permet de recristalliser la couche de silicium 26 sous forme monocristalline ainsi que d'enfoncer verticalement dans le substrat 12 les motifs d'oxyde 17. La structure obtenue est représentée sur la figure 9.

Ce traitement thermique consiste à chauffer le substrat 12 par l'arrière, comme schématisé par la flèche $F_1$, c'est-à-dire la face 12a dudit substrat opposé au film de silicium 26. Le chauffage du substrat 12 est effectué de façon uniforme à une température relativement élevée mais inférieure à la température de fusion du silicium monocristallin constituant le substrat, c'est-à-dire à une température de l'ordre de 1 300 °C. Ceci peut être réalisé par exemple en disposant le substrat 12 sur une plaque chauffante en graphite portant la référence 30 sur la figure 7.

On réalise d'autre part, mais simultanément au chauffage du substrat 12, un chauffage du film de silicium 26, à travers la couche encapsulante 28, en utilisant une source de chauffage 32 de forme allongée constituée par exemple par un barreau de graphite chauffé (figure 7) ou une lampe linéaire focalisée, ou un autre faisceau d'énergie focalisé et linéaire. Ce chauffage du film 26 est réalisé en effectuant un balayage relatif entre la source 32 et l'échantillon et donc le film 26, par exemple en maintenant fixe l'échantillon, donc le film, et en déplaçant la source 32 sur toute la surface de l'échantillon, comme représenté par la

flèche $F_2$.

Il est à noter que le chauffage du substrat 12 peut aussi être réalisé en utilisant une batterie de lampes linéaires placées parallèlement à la source linéaire supérieure 32.

Ces chauffages simultanés du substrat 12 et du film 26 de silicium permettent d'induire une zone fondue superficielle de silicium se déplaçant sur toute la surface du film et du substrat. Comme représenté sur la figure 7, le déplacement de la source 32 est réalisé parallèlement aux motifs isolants 17, qui présentent la forme de bandes continues parallèles.

La profondeur à laquelle peuvent s'enfoncer les motifs d'isolant 17 peut être ajustée avec précision en jouant sur la vitesse de balayage de la source 32 et sur la largeur de la zone fondue superficielle se déplaçant, cette largeur correspondant à la largeur de la source 32. Par exemple une source de 5 mm de large et de vitesse de déplacement de 0,2 mm/s permet d'enfoncer dans le substrat des motifs d'isolant 17 à une profondeur de 20 μm.

Un tel dispositif de chauffage a notamment été décrit dans un article du Journal of Crystal Growth (63) de 1983 intitulé « Graphite strip-heater zone-melting recrystallization of Si films » de J.C.C. FAN et al.

Comme autre dispositif de chauffage utilisable dans l'invention, on peut citer celui décrit dans la demande de brevet français n° 2532783 déposée le 7 septembre 1982, utilisant des lampes linéaires focalisées du côté du film.

Le fait que les motifs d'isolant s'enfoncent verticalement dans le substrat, sans décalage latéral par rapport à leur position initiale, permet de les localiser par rapport à la surface de l'échantillon qui garde le relief initial, et donc de rendre possible l'alignement des étapes ultérieures nécessaires à la fabrication des îlots monocristallins. Cet alignement est facilité lorsque les motifs isolants sont obtenus par la technologie dite LOCOS ou LOCOS enterré (figure 6).

Le silicium précédemment fondu se trouvant au-dessus des motifs isolants 17 enfoncés se recristallise en se refroidissant. Il est exempt de tout défaut cristallin et présente une surface absolument plane et lisse. La couche de silicium monocristalline obtenue, surmontant les motifs isolants, porte la référence 33.

L'étape suivante du procédé consiste, comme représenté sur la figure 10, à éliminer la couche encapsulante 28 par exemple par voie chimique dans un bain d'acide fluorhydrique lorsque cette couche 28 est réalisée en oxyde de silicium ou dans un bain d'acide orthophosphorique pour une couche en nitrure de silicium.

Les étapes suivantes du procédé consistent à graver la couche de silicium monocristallin 33 obtenue au-dessus des motifs d'oxyde 17 pour former dans cette couche des îlots de silicium monocristallins isolés les uns des autres.

Pour cela, on dépose tout d'abord, sur la couche de silicium monocristalline 33, comme représenté sur la figure 10, une couche 30 d'un matériau insensible aux agents d'attaque de la couche 33. Ce dépôt peut être fait par un procédé de dépôt chimique en phase vapeur. Cette couche 30 présentant une épaisseur d'environ 100 nm peut être réalisée en oxyde de silicium ou en nitrure de silicium.

Sur cette couche d'isolant 30, on réalise ensuite, par les procédés classiques de la photolithographie, un masque de résine 31 représentant l'image des motifs d'isolants 33 noyés dans le silicium monocristallin et permettant de masquer lesdits motifs. Le fait que la couche 33 en silicium monocristallin présente un relief correspondant au relief avant enfoncement des motifs isolants 17 permet de positionner correctement le masque de résine 31.

On réalise ensuite, comme représenté sur la figure 11, une gravure de la couche isolante 30 de façon à éliminer les régions de la couche 30 non masquées jusqu'à mise à nu de la couche monocristalline 33. Cette gravure peut par exemple être réalisée de façon isotrope par voie chimique, en utilisant respectivement comme agent d'attaque de l'acide fluorhydrique ou orthophosphorique pour une couche 30 en oxyde de silicium ou en nitrure de silicium, ou bien par une gravure anisotrope en utilisant un plasma d'oxygène.

Après élimination du masque de résine 31, notamment par voie chimique avec de l'acétone ou de l'acide nitrique comme agent d'attaque, on élimine, comme représenté sur la figure 12, les régions de la couche de silicium monocristallin 33 dépourvues du restant de la couche protectrice 30. Cette élimination peut être réalisée de façon isotrope en utilisant par exemple un procédé de gravure chimique utilisant une solution de potasse comme agent d'attaque. Cette gravure est effectuée jusqu'au niveau des motifs isolants 17, les flancs de ces motifs étant mis à nu. Elle permet d'obtenir des îlots de silicium monocristallin portant la référence 34, nettement séparés les uns des autres.

Après gravure de la couche monocristalline 33 et donc réalisation des îlots 34, le restant de la couche d'isolant 30, ayant servi de masque à ladite gravure, peut être éliminé par exemple par voie chimique en utilisant de l'acide fluorhydrique pour une couche 30 en oxyde de silicium ou de l'acide orthophosphorique pour une couche 30 en nitrure de silicium.

L'étape suivante du procédé consiste à isoler électriquement, de façon efficace, les îlots monocristallins 34 les uns des autres. Cette isolation peut être faite en recouvrant la structure obtenue par une couche isolante 36 réalisée notamment en oxyde de silicium. Cette couche isolante 36, présentant une épaisseur de plusieurs centaines de nanomètres peut être obtenue par oxydation thermique sous oxygène des régions du substrat 12 mises à nu ainsi que des îlots monocristallins 34.

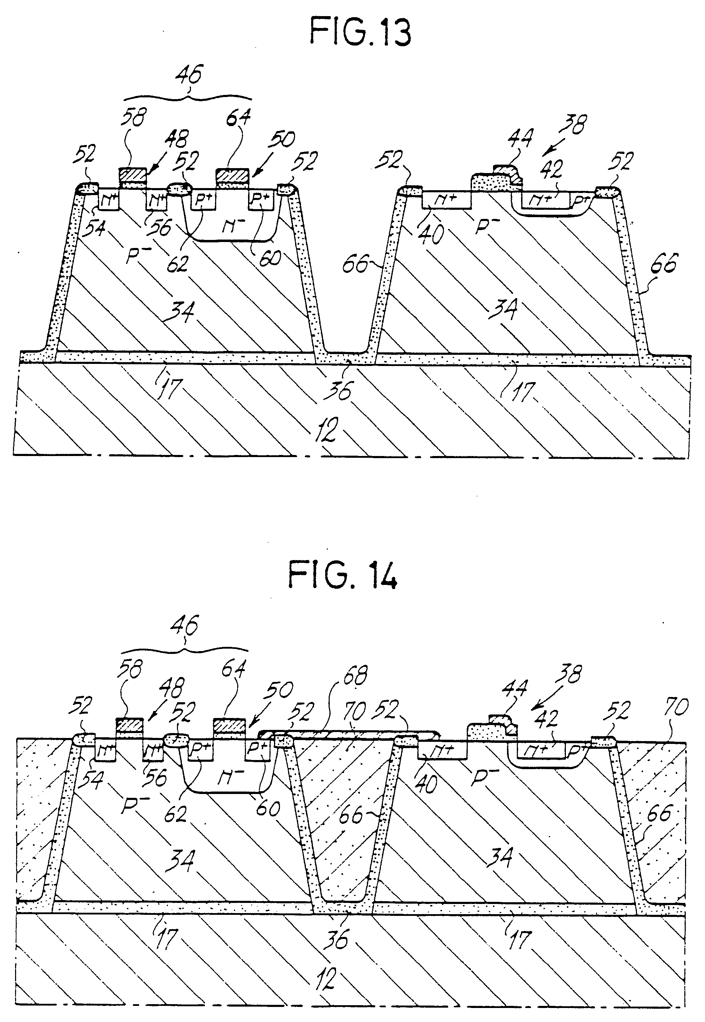

Cette couche d'oxyde 36 peut ensuite être gravée de façon à ne garder de cette couche que les parties se trouvant sur les flancs des îlots monocristallins 34 et sur les régions du substrat 12 situées entre deux îlots contigus. La structure résultant de cette gravure est représentée sur la figure 13. Comme précédemment, l'élimination de certaines parties de la couche isolante 36 peut être réalisée en utilisant un masque, non représenté, recouvrant la surface des îlots monocristallins 34 et en utilisant un procédé de gravure anisotrope ou isotrope tel qu'une attaque chimique avec de l'acide fluorhydrique.

De façon classique, on peut ensuite réaliser dans les îlots monocristallins 34, isolés électriquement les uns des autres, les composants actifs d'un même circuit intégré et en particulier des composants fonctionnant sous haute tension, tels que des transistors DMOS ou bipolaires, isolés de composants fonctionnant sous basse tension, tels que des transistors N-MOS, CMOS ou bipolaires.

Sur la figure 13, on a représenté un transistor DMOS 38 réalisé sur un premier îlot monocristallin, comportant de façon classique une source 40 et un drain 42, diffusés dans ledit îlot, ainsi qu'une grille 44, isolée de la source et du drain, et un inverseur CMOS 46 réalisé sur un second îlot monocristallin formé d'un transistor 48 à canal N et d'un transistor 50 à canal P, isolés l'un de l'autre par un oxyde de champ 52 obtenu de façon classique. Le transistor 48 comporte de façon connue une source 54, un drain 56 et une grille 58 isolée de la source et du drain, et le transistor 50 comporte une source 60, un drain 62 et une grille 64.

Les différents composants réalisés dans les îlots de silicium monocristallin 34, tels que l'inverseur CMOS 46 et le transistor DMOS 38 sont fabriqués de façon classique jusqu'à l'étape de métallisation servant à réaliser les interconnexions de ces composants. En effet, avant d'effectuer cette métallisation, on procède conformément à l'invention à un remplissage des trous ou espaces 66 se trouvant entre les différents îlots monocristallins 34. Ce remplissage, comme représenté sur la figure 14, peut être effectué avec une résine polyimide 70 que l'on dépose sur l'ensemble de la structure à la tournette puis que l'on grave de façon à éliminer les parties de ladite résine se trouvant en dehors des espaces ou trous 66. Cette élimination peut être réalisée par un procédé de gravure ionique réactive utilisant une méthode dite de planarisation.

On peut alors réaliser, de façon classique, les interconnexions des différents composants du circuit intégré et en particulier la connexion 68 entre le composant basse tension CMOS 46 et le composant haute tension DMOS 38. Ces interconnexions sont réalisées en déposant sur l'ensemble de la structure une couche conductrice, notamment en aluminium, d'une épaisseur de 1 μm, puis en gravant ladite couche de façon à réaliser les différentes connexions.

Bien entendu, la description précédente n'a été donnée qu'à titre illustratif. En particulier, toutes modifications pouvant intervenir dans la matière des couches de matériau, dans leur épaisseur, dans leurs procédés de dépôt et de gravure peuvent être envisagées.

## Revendications

1. Procédé de fabrication d'îlots de silicium monocristallin isolés électriquement les uns des autres, comprenant les étapes successives suivantes :

   a) réalisation de bandes parallèles continues (17, 24) en un premier matériau isolant sur un substrat (12) en silicium monocristallin,

   b) dépôt sur l'ensemble de la structure d'un film (26) de silicium non-monocristallin,

   c) recouvrement du film (26) de silicium d'une couche continue (28) d'un matériau encapsulant,

   d) réalisation d'un traitement thermique de la structure obtenue servant à enfoncer verticalement dans le substrat (12) les bandes (17, 24) de premier matériau isolant et à former au-dessus de ces bandes (17, 24) enfoncées une couche de silicium monocristallin (33), ce traitement thermique, consistant à chauffer d'une part la face (12a) du substrat en silicium (12) opposée au film de silicium (26), de façon uniforme, à une température inférieure à la température de fusion du silicium et, d'autre part, le film de silicium (26), en effectuant un balayage relatif entre une source de chauffage (32) et le film, suivant une direction (F₂) parallèle auxdites bandes (17), ces chauffages simultanés du film (26) et de ladite face (12a) du substrat (12) induisant une zone fondue de silicium se déplaçant sur toute la surface du film et du substrat selon ladite direction,

   e) éliminer la couche (28) de matériau encapsulant, et

   f) graver la couche de silicium monocristallin obtenue (33) de façon à former lesdits îlots (34).

2. Procédé de fabrication selon la revendication 1, caractérisé en ce que le film de silicium non-monocristallin est un film de silicium amorphe.

3. Procédé de fabrication selon la revendication 1, caractérisé en ce que le film de silicium non-monocristallin est un film de silicium polycristallin.

4. Procédé de fabrication selon l'une quelconque des revendications 1 à 3, caractérisé en ce que les bandes parallèles continues (17) sont régulièrement espacées les unes des autres.

5. Procédé de fabrication selon l'une quelconque des revendications 1 à 4, caractérisé en ce que l'on réalise les bandes (17) de premier matériau isolant en recouvrant le substrat (12) d'une couche (14) dudit premier matériau et en gravant ladite couche (14) de premier matériau jusqu'à mise à nu de certaines zones du substrat (12).

6. Procédé de fabrication selon l'une quelconque des revendications 1 à 4, caractérisé en ce que l'on réalise les bandes (24) de premier matériau en effectuant les étapes suivantes :

   1) recouvrement du substrat (12) d'au moins une couche préliminaire (18, 20) de matériau isolant,

   2) gravure de ladite couche préliminaire (18, 20) de façon à réaliser dans cette couche des motifs complémentaires (18a, 20a) de ceux (24) à obtenir, jusqu'à mise à nu de certaines zones du substrat,

3) oxydation thermique des zones du substrat (12) mises à nu, et

4) élimination du restant de la couche préliminaire (18a, 20a).

7. Procédé de fabrication selon la revendication 6, caractérisé en ce que l'on effectue après l'étape 2) une gravure des zones du substrat mises à nu sur une hauteur donnée.

8. Procédé de fabrication selon l'une quelconque des revendications 1 à 7, caractérisé en ce que le premier matériau est de l'oxyde de silicium.

9. Procédé de fabrication selon l'une quelconque des revendications 1 à 8 caractérisé en ce que la couche (28) de matériau encapsulant est formée d'une couche d'oxyde de silicium et/ou d'une couche de nitrure de silicium.

10. Procédé de fabrication selon l'une quelconque des revendications 1 à 9, caractérisé en ce que le chauffage du film (26) est effectué au moyen d'une source de chauffage (32) de forme allongée.

11. Procédé de fabrication selon l'une quelconque des revendications 1 à 10, caractérisé en ce que l'on effectue l'étape f) de façon suivante :

réalisation d'un masque (30) sur la couche de silicium obtenue (33) représentant l'image des bandes (17, 24) en premier matériau,

élimination des régions de la couche de silicium (33) non masquées jusqu'au niveau des bandes (17, 24) de premier matériau enfoncées dans le substrat (12), et

élimination du masque (30).

12. Procédé de fabrication selon la revendication 11, caractérisé en ce que le masque (30) est réalisé en oxyde de silicium ou en nitrure de silicium.

13. Procédé de fabrication selon l'une quelconque des revendications 1 à 12, caractérisé en ce qu'après l'étape f), on recouvre les flancs des îlots et les régions du substrat mises à nu entre lesdits îlots d'une couche (36) d'un second matériau isolant.

14. Procédé de fabrication selon l'une quelconque des revendications 1 à 13, caractérisé en ce qu'après l'étape f), on effectue un remplissage des espaces (66) compris entre les îlots (34) par un troisième matériau (70).

15. Procédé de fabrication selon la revendication 14, caractérisé en ce que le remplissage des espaces (66) est réalisé en déposant sur l'ensemble de la structure une couche dudit troisième matériau (70) et en éliminant ledit troisième matériau se trouvant en dehors desdits espaces (66).

16. Procédé de fabrication selon la revendication 14 ou 15, caractérisé en ce que le troisième matériau est une résine polyimide.

17. Procédé de fabrication selon l'une quelconque des revendications 1 à 16, caractérisé en ce que le film (26) de silicium présente une épaisseur d'environ 0,5 µm.

## Claims

1. Process for the production of mutually electrically insulated monocrystalline silicon islands, characterized in that it comprises the following successive stages :

a) producing patterns (17, 24) of a first insulating material on a monocrystalline substrate (12),

b) deposition of a silicon film (26) on the complete structure,

c) covering the silicon film (26) with a layer (28) of an encapsulating material,

d) carrying out a heat treatment on the structure obtained and serving to vertically embed in the substrate (12) the patterns (17, 24) of the first insulating material and for forming above said embedded patterns (17, 24) a monocrystalline silicon layer (33), said heat treatment consisting of heating the face (12a) of the silicon (12) substrate opposite to the silicon film (26) in a uniform manner at a temperature below the silicon melting temperature and the silicon film (26) by performing a relative sweep between a heating source (32) and the film in a direction (F$_2$) parallel to said strips (17), said simultaneous heating operations of the film (26) and the substrate (12) face (12a) inducing a melted silicon zone moving over the entire surface of the film and the substrate in said direction,

e) eliminating the encapsulating material layer (28),

f) etching the monocrystalline silicon layer obtained (33), so as to form said islands (34).

2. Production process according to claim 1, characterized in that the silicon film is an amorphous silicon film.

3. Production process according to claim 1, characterized in that the silicon film is a polycrystalline silicon film.

4. Production process according to one of the claims 1 to 3, characterized in that the first insulating material patterns (17) are in the form of continuous parallel strips, which are regularly spaced from one another.

5. Production process according to one of the claims 1 to 4, characterized in that the patterns (17) of the first insulating material are produced by covering the substrate (12) with a layer (14) of said first material and then etching said layer (14) until certain zones of substrate (12) are exposed.

6. Production process according to one of the claims 1 to 5, characterized in that the first material patterns (24) are obtained by performing the following stages :

1) covering substrate (12) with at least one preliminary layer (18, 20) of insulating material,

2) etching said preliminary layer (18, 20), so as to produce in said layer patterns (18a, 20a) complementary to those (24) to be obtained and until certain substrate zones are exposed,

3) thermal oxidation of the exposed zones of substrate (12) and

4) elimination of the remainder of the preliminary layer (18a, 20a).

7. Production process according to claim 6, characterized in that following stage 2), the exposed substrate zones are etched over a given height.

8. Production process according to any one of the claims 1 to 7, characterized in that the first material is silicon oxide.

9. Production process according to any one of the claims 1 to 8, characterized in that the encapsulating material layer (28) is formed from a silicon oxide layer and/or a silicon nitride layer.

10. Production process according to any one of the claims 1 to 9, characterized in that the heating of the film (26) takes place by means of an elongated heating source (32).

11. Production process according to any one of the claims 1 to 10, characterized in that stage f) is performed in the following way : producing a mask (32) on the silicon layer (33) obtained, which represents the image of the patterns (17, 24) of the first material,

elimination of the regions of the silicon layer (33) which have not been masked up to the level of the patterns (17, 24) of the first material embedded in substrate (12) and

elimination of mask (32).

12. Production process according to claim 11, characterized in that mask (32) is made from silicon oxide or silicon nitride.

13. Production process according to any one of the claims 1 to 12, characterized in that following stage f), the flanks of the islands and the substrate regions exposed between said islands are covered with a layer (36) of a second insulating material.

14. Production process according to any one of the claims 1 to 13, characterized in that following stage f), spaces (66) between islands (34) are filled with a third material (68).

15. Production process according to claim 14, characterized in that the filling of the spaces (66) is carried out by depositing on the complete structure a layer of said third material and by eliminating the third material (70) located outside said spaces (66).

16. Production process according to claims 14 or 15, characterized in that the third material is a polyimide resin.

17. Production process according to any one of the claims 1 to 16, characterized in that the silicon film (26) has a thickness of about 0.5 $\mu$m.

**Patentansprüche**

1. Verfahren zur Herstellung von gegenseitig isolierten Inseln aus monokristallinem Silizium, mit den nachstehenden, aufeinanderfolgenden Schritten :

a) Erzeugen von durchgehenden parallelen Bändern (17, 24) aus einem ersten isolierenden Material auf einem Substrat (12) aus monokristallinem Silizium,

b) Aufbringen einer Schicht (26) aus nicht-monokristallinem Silizium auf dem Gesamtaufbau,

c) Bedecken der Siliziumschicht (26) mit einer durchgehenden Schicht (28) aus einem Abdeckmaterial,

d) Durchführen einer thermischen Behandlung dieses erhaltenen Aufbaus zum senkrechten Eindrucken der Bänder (17, 24) aus dem ersten isolierenden Material in das Substrat (12) und zum Ausbilden einer Schicht aus monokristallinem Silizium (33) oberhalb der eingedrückten Bänder (17, 24), in dem einerseits die der Siliziumschicht (26) abgewandte Fläche (12a) des Siliziumsubstrats (12) gleichförmig auf eine Temperatur unterhalb der Schmelztemperatur des Siliziums erwärmt wird und andererseits die Siliziumschicht (26), wobei eine Relativverschiebung zwischen der Wärmequelle (32) und der Schicht erfolgt entlang einer Richtung $F_2$ parallel zu den Bändern (17), so daß diese gleichzeitigen Erwärmungen der Schicht (26) und der Fläche (12a) des Substrates (12) einen Abschnitt an geschmolzenem Silizium erzeugen, der sich über die gesamte Fläche der Schicht und des Substrats entlang der genannten Richtung bewegt,

e) Entfernen der Schicht (28) aus Abdeckmaterial und

f) Ätzen der so erhaltenen monokristallinen Siliziumschicht (33) derart, daß Inseln (34) entstehen.

2. Verfahren nach Anspruch 1, dadurch gekennzeichnet, daß die Schicht aus nicht- monokristallinem Silizium eine Schicht aus amorphem Silizium ist.

3. Verfahren nach Anspruch 1, dadurch gekennzeichnet, daß die Schicht aus nicht, monokristallinem Silizium eine Schicht aus polykristallinem Silizium ist.

4. Verfahren nach einem der Ansprüche 1 bis 3, dadurch gekennzeichnet, daß die durchgehenden parallelen Bänder (17) im gleichmäßigen Abstand voneinander angeordnet sind.

5. Verfahren nach einem der Ansprüche 1 bis 4, dadurch gekennzeichnet, daß die Bänder (17) aus dem ersten isolierenden Material erzeugt werden, indem das Substrat (12) mit einer Schicht (14) aus diesem ersten Material bedeckt wird und indem die Schicht (14) aus dem ersten isolierenden Material so lange geätzt wird, bis bestimmte Bereiche des Substrates (12) bloßliegen.

6. Verfahren nach einem der Ansprüche 1 bis 5, dadurch gekennzeichnet, daß die Bänder (24) aus dem ersten Material erzeugt werden, indem die folgenden Schritte durchgeführt werden :

1) Beschichten des Substrats (12) mit wenigstens einer vorläufigen Schicht (18, 20) aus isolierendem Material,

2) Ätzen dieser vorläufigen Schicht (18, 20) derart, daß in dieser Schicht komplementäre Strukturen (18a, 20a) entstehen zu denjenigen (24), die zu erzeugen sind, bis bestimmte Bereiche des Substrates bloßliegen,

3) thermisches Oxidieren der bloßliegenden Bereiche des Substrates (12) und

4) Entfernen der restlichen vorläufigen Schicht (18a, 20a).

7. Verfahren nach Anspruch 6, dadurch gekennzeichnet, daß nach dem zweiten Schritt 2) ein Ätzen der bloßliegenden Bereiche des Substrates auf eine gegebene Höhe erfolgt.

8. Verfahren nach einem der Ansprüche 1 bis 7, dadurch gekennzeichnet, daß das erste Material aus Siliziumoxid besteht.

9. Verfahren nach einem der Ansprüche 1 bis 8, dadurch gekennzeichnet, daß die Schicht (28) aus Abdeckmaterial aus einer Siliziumoxidschicht und/oder einer Siliziumnitridschicht besteht.

10. Verfahren nach einem der Ansprüche 1 bis 9, dadurch gekennzeichnet, daß das Erwärmen der Schicht (26) mittels einer langgestreckten Wärmequelle (32) erfolgt.

11. Verfahren nach einem der Ansprüche 1 bis 10, dadurch gekennzeichnet, daß der Schritt f) wie folgt durchgeführt wird :

Erzeugen einer Maske (32) auf der erhaltenen Siliziumschicht (33), welche die Bilder der Bänder (17, 24) aus dem ersten Material darstellt,

Entfernen der nicht abgedeckten Bereiche der Siliziumschicht (33) bis auf Höhe der Bänder (17, 24) aus dem ersten Material, die in das Substrat (12) eingedrückt sind und

Entfernen der Maske (32).

12. Verfahren nach Anspruch 11, dadurch gekennzeichnet, daß die Maske (32) aus Siliziumoxid oder aus Siliziumnitrid besteht.

13. Verfahren nach einem der Ansprüche 1 bis 12, dadurch gekennzeichnet, daß nach dem Schritt f) die Flanken der Inseln und die bloßliegenden Abschnitte des Substrats zwischen den Inseln mit einer Schicht (36) aus einem zweiten isolierenden Material bedeckt werden.

14. Verfahren nach einem der Ansprüche 1 bis 13, dadurch gekennzeichnet, daß nach dem Schritt f) ein Ausfüllen der Räume (66) zwischen den Inseln (34) mittels eines dritten Materials (68) erfolgt.

15. Verfahren nach Anspruch 14, dadurch gekennzeichnet, daß das Ausfüllen der Räume (66) dadurch erfolgt, daß auf dem gesamten Aufbau eine Schicht aus dem dritten Material (70) abgelagert wird und daß das dritte Material außerhalb der Räume (66) entfernt wird.

16. Verfahren nach Anspruch 14 oder 15, dadurch gekennzeichnet, daß das dritte Material aus einem Polyimid-Harz besteht.

17. Verfahren nach einem der Ansprüche 1 bis 16, dadurch gekennzeichnet, daß die Siliziumschicht (26) eine Dicke von ungefähr 0,5 $\mu$m aufweist.

FIG.1

FIG.2    FIG.3

FIG.4    FIG.5

FIG.6    FIG.7

FIG.8

FIG.9

## FIG. 10

31

30

33

17

17

12

## FIG.11

30

33

17

17

12

## FIG.12

36

34

34

17 (SiO₂)

17 (SiO₂)

12 (Si)

# FIG.13

# FIG. 14